# EUROPÄISCHE PATENTSCHRIFT

(11) **EP 1 616 344 B1**
(45) Veröffentlichungstag und Bekanntmachung des Hinweises auf die Patenterteilung: **13.08.2008**
(21) Anmeldenummer: 04726458.5
(22) Anmeldetag: 08.04.2004
(51) Int. Cl.: G11B 7/24, G11B 7/0065

(54) **RÄUMLICH HOCHAUFGELÖSTES ERZEUGEN EINER DAUERHAFTEN STRUKTUR**
CREATION OF A PERMANENT STRUCTURE WITH HIGH THREE-DIMENSIONAL RESOLUTION
PRODUCTION HAUTE RESOLUTION SPATIALE D'UNE STRUCTURE DURABLE

(30) Priorität: 13.04.2003 DE 10317613; 22.04.2003 US 420896; 05.06.2003 DE 10325459
(43) Veröffentlichungstag der Anmeldung: 18.01.2006
(73) Patentinhaber: Max-Planck-Gesellschaft zur Förderung der Wissenschaften e.V., 80539 München (DE)
(72) Erfinder: HELL, Stefan, 37073 Göttingen (DE)
(74) Vertreter: Rehberg Hüppe + Partner
(86) Internationale Anmeldenummer: PCT/EP2004/003768
(87) Internationale Veröffentlichungsnummer: WO 2004/090950

(56) Entgegenhaltungen:
- WO-A-98/31018
- WO-A2-01/94384
- US-A- 5 268 862
- "Write, read, erase materials for 3D optical memory devices" SPIE PROCEEDINGS, Bd. 3802, Juli 1999 (1999-07), Seiten 192-200, XP002411086
- CINELLI RICCARDO A G ET AL: "Green fluorescent proteins as optically controllable elements in bioelectronics" APPLIED PHYSICS LETTERS, AIP, AMERICAN INSTITUTE OF PHYSICS, MELVILLE, NY, US, Bd. 79, Nr. 20, 12. November 2001 (2001-11-12), Seiten 3353-3355, XP012029442 ISSN: 0003-6951

## Beschreibung

Die Erfindung betrifft ein Verfahren zum räumlich hochaufgelösten Erzeugen einer dauerhaften Struktur unter Verwendung eines optischen Signals mit den Merkmalen des Oberbegriffs des Patentanspruchs 1. Weiterhin betrifft die Erfindung eine Vorrichtung mit einem unter Verwendung eines optischen Signals dauerhaft strukturierbaren Schreibbereich nach dem Oberbegriff des Patentanspruchs 22. Die Erfindung kann insbesondere beim Schreiben in einen optischen Datenspeicher und beim Ausbilden mikrolithographischer Strukturen Anwendung finden.

Die Dauerhaftigkeit der mit dem Verfahren bzw. bei der Vorrichtung erzeugten Struktur soll zumindest für einen Zeitraum viel größer als 1 Minute und vorzugsweise für einen Zeitraum viel größer als 1 Tag oder noch mehr bevorzugt bis zum gewollten Ändern oder Löschen der Struktur gegeben sein, so dass die erzeugte Struktur auch mit größerem zeitlichen Abstand zu ihrer Erzeugung nutzbar ist.

### STAND DER TECHNIK

Bei einem bekannten Verfahren nach dem Oberbegriff des Anspruchs 1, bei dem eine Vorrichtung nach dem Oberbegriff des Anspruchs 24 verwendet wird, wird eine Schicht aus Photolack mit dem optischen Signal überall dort belichtet, wo sie dauerhaft verändert werden soll. Dabei besteht die gewünschte Struktur nicht aus den veränderten Teilbereichen des Schreibbereichs sondern aus den mit dem optischen Signal gezielt ausgelassenen Teilbereichen.

Die räumliche Auflösung sowohl abbildender als auch modifizierender optischer Verfahren wird grundsätzlich durch die von der Wellenlänge des verwendeten Lichts abhängige Beugungsgrenze (Abbe'sche Grenze) gesetzt.

So ist die Beugungsgrenze bei allen bekannten Verfahren zum räumlich hochaufgelösten Erzeugen einer dauerhaften Struktur unter Verwendung eines optischen Signals die natürliche Untergrenze für die Auflösung beispielsweise beim Schreiben von Daten in einen optischen Datenspeicher und damit für die in dem Datenspeicher erreichbare Datendichte oder bei der Mikrolithographie. Um immer kleinere Strukturen zu erzeugen, z. B. in einem Photoresist, ist man daher bislang gezwungen, zu immer kürzeren Wellenlängen überzugehen. Zur Zeit verwendet man daher fernes UV-Licht (englisch: deep-UV light), für die Zukunft wird die Verwendung von Röntgenlicht angestrebt. Ein Problem dabei ist, dass Licht mit einer Wellenlänge <250 nm schwer zu fokussieren ist und die zu verwendeten Optiken teuer und ineffizient werden.

Auf dem Gebiet der Fluoreszenzmikroskopie sind bereits Verfahren bekannt, bei denen durch Ausnutzung von nichtlinearen Zusammenhängen zwischen der Schärfe des effektiven fokalen Spots und der eingestrahlten Intensität die Beugungsgrenze bei der Abbildung einer Struktur einer Probe effektiv unterschritten wird. Beispiele sind die Multiphotonenabsorption in der Probe oder die Erzeugung höherer Harmonischer des einfallenden Lichts. Auch eine Sättigung eines optisch induzierten Übergangs kann als nichtlinearen Zusammenhang ausgenutzt werden, wie beispielsweise bei einer Entvölkerung des fluoreszierenden Zustands durch stimulierte Emission (englisch: stimulated emission depletion = STED) oder einer Entvölkerung des Grundzustands (englisch: ground state depletion = GSD). Bei diesen beiden Verfahren, die prinzipiell molekulare Auflösungen erreichen können, wird ein Fluoreszenzfarbstoff, mit dem die interessierende Struktur einer Probe markiert ist, überall dort, wo ein optisches Signal einen charakteristischen Grenzwert, d.h. einen Sättigungsgrenzwert, überschreitet, in einen Energiezustand versetzt, aus dem heraus keine Fluoreszenz (mehr) erfolgt. Wenn der räumliche Bereich, aus dem dann noch ein Messsignal registriert wird, durch ein lokales Intensitätsminimum des optischen Signals festgelegt wird, das eine Nullstelle aufweist und beispielsweise durch Interferenz erzeugt wird, sind seine Abmessungen und damit die erreichte Ortsauflösung kleiner als die Beugungsgrenze. Der Grund ist, dass der räumliche begrenzte Teilbereich, aus dem das Messsignal registriert wird, mit zunehmenden Sättigungsgrad der Entvölkerung des an der Fluoreszenz beteiligten Zustands eingeengt wird. Genauso wird die Kante eines fokalen Spots oder Streifens steiler, was ebenfalls zu einer erhöhten Ortsauflösung führt.

Ein konkretes STED-Verfahren ist aus der WO 95/21393 A1 bekannt. Bei diesem Verfahren wird eine Probe bzw. ein Fluoreszenzfarbstoff in der Probe durch ein optisches Anregungssignal zur Fluoreszenz angeregt. Der räumliche Teilbereich der Anregung, für den normalerweise die Beugungsgrenze gilt, wird dann verkleinert, indem er mit einem Intensitätsminimum eines Interferenzmusters eines optischen Abregungssignals überlagert wird. Überall dort, wo das Abregungssignal einen Sättigungsgrenzwert übersteigt, wird der Fluoreszenzfarbstoff zumindest im Wesentlichen vollständig durch stimulierte Emission ausgeschaltet, d.h. aus dem zuvor angeregten Energiezustand wieder abgeregt. Der verbleibende räumliche Teilbereich, aus dem anschließend noch Fluoreszenzlicht spontan emittiert wird, entspricht nur noch einem verkleinerten Gebiet um die Nullstelle des Intensitätsminimums, in dem das Abregungssignal nicht oder nicht mit ausreichender Intensität vorlag.

Aus The Journal of Biological Chemistry, Vol. 275, No. 84, Seiten 25879-25882 (2000), ist ein Protein bekannt, das durch grünes Licht in zunehmendem Maße zur Fluoreszenz im roten Bereich anregbar ist, das aber bei Bestrahlung mit blauem Licht seine Fluoreszenzeigenschaften verliert. Dieser Prozess ist umkehrbar. Offenbar schaltet das grüne Licht das Protein in einen Konformationszustand, in dem es die Fluoreszenzeigenschaft hat, und regt gleichzeitig die Fluoreszenz an, während das blaue Licht das Protein in einen Konformationszustand ohne die Fluoreszenzeigenschaften umschaltet. Das Protein ist ein in der Seeanemone Anemonia sulcata vorkommendes natürliches Protein, dessen hier beschriebenen Funktionen durch gezielten Austausch einer Aminosäure verstärkt werden können.

Weiterhin ist es aus der Zeitschrift Nature Vol. 388, Seiten 355-358, (1997) bekannt, dass das Grün-Fluoreszierende-Protein (englisch: green-fluorescent protein, GFP) und Mutanten davon zwischen zwei Zuständen geschaltet werden können, wobei der eine sich von dem anderen spektral unterscheidet. Beide Proteine können als Fluoreszenzmarker in lebenden Zellen eingesetzt werden.

Aus der Publikation Nature, Vol. 420, Seiten 759-760, (2002) sind fluoreszierende Moleküle aus der Familie der Diarylethenen bekannt, die sich zwischen einen fluoreszierenden und einem nichtfluoreszierenden Zustand beliebig hin- und herschalten lassen. Beide Zustände sind thermisch stabil, so dass der Schaltprozess, bei dem es sich um eine Photoisomerisierung oder Photocyclisierung handelt, mit vergleichweise niedrigen Intensitäten eines optischen Signals erzwungen werden kann. Moleküle, die unter Lichteinfluss ihre Farbe verändern, werden im allgemeinen als photochromenen Moleküle bezeichnet.

### AUFGABE DER ERFINDUNG

Der Erfindung liegt die: Aufgabe zugrunde, ein Verfahren nach dem Oberbegriff des Patentanspruchs 1 aufzuzeigen, bei dem die Betigungsgrenze beim Erzeugen von dauerhaften Strukturen unter Verwendung eines optischen Signals unterschreitbar ist. Weiterhin soll eine für ein solches Verfahren geeignete Vorrichtung nach dem Oberbegriff des Patentanspruchs 22 aufgezeigt werden.

### ZUSAMMENFASSUNG DER ERFINDUNG

Die Aufgabe der Erfindung wird durch ein Verfahren mit den Merkmalen des Patentanspruchs 1 und eine Vorrichtung mit den Merkmalen des Patentanspruchs 22 gelöst.

Vorteilhafte Ausführungsformen des Verfahrens und der Vorrichtung sind in den abhängigen Ansprüchen beschrieben, wobei die Unteransprüche 20 und 21 konkrete Anwendungen des neuen Verfahrens betreffen und wobei sich weitere vorteilhafte Ausführungsformen der neuen Vorrichtung auch aus den abhängigen Ansprüchen zu dem Verfahren ableiten lassen.

### BESCHREIBUNG DER ERFINDUNG

Bei dem neuen Verfahren ist der von dem optischen Signal gezielt ausgelassene Teilbereich, - in dem keine oder zumindest im Wesentlichen keine Veränderung der Substanz erfolgt, ein lokales intensitätsminimum des optischen Signals. Gleichzeitig wird das optische Signal außerhalb des gezielt ausgelassenen räumlich begrenzten Teilbereichs so aufgebracht, dass beim Verändern der Substanz mit dem optischen Teilbereich die Sättigung erreicht wird. Im Ergebnis sind die Abmessungen des Teilbereichs, in dem die Substanz durch das optische Signal nicht verändert ist, kleiner als die Beugungsgrenze.

Aus der WO 98/31018 ist ein Verfahren zum Aufzeichnen von Informationen innerhalb eines dreidimensionalen Speichersystems bekannt, das eine Matrix aufweist, die ein aktives photochromes Material trägt. Das Verfahren weist das Belichten der Matrix mit einer ersten elektromagnetischen Strahlung auf, um innerhalb des Materials eine photochemische Reaktion zu induzieren, die dem Aufzeichnen der Informationen entspricht, wobei während dieser Reaktion eine erste Form A des Materials, die bei Beleuchtung desselben mit der ersten Strahlung nicht fluoreszent ist, in eine zweite Form B des Materials umgewandelt wird, die bei Beleuchtung desselben mit einer zweiten elektromagnetischen Strahlung fluoreszent ist, wobei die erste und die zweite elektromagnetische Strahlung unterschiedliche Wellenlängen aufweisen und wobei die photochemische Reaktion eine Transformation einer nicht fluoreszenten Spiropyranform in eine fluoreszente Merozyaninform des Materials ist.

Aus der WO 01/94384 A2 ist die Verwendung von Rhodopsin-artigem Protein, das aus dem Photorezeptor von *Euglena gracilis* extrahierbar ist, bei der Herstellung von optoelektronischen Einrichtungen bekannt. Konkret können z. B. dreidimensionale Arrays als nichtlineare Volumenspeicher, nämlich Zweiphotonenspeicher eingesetzt werden. Das hier beschriebene Protein weist eine nicht fluoreszente Ausgangsform auf, die bei Photoanregung bei 365 nm eine grünfluoreszente stabile Zwischenform aufweist, die photochemisch unter Verwendung einer Anregung bei 436 nm in die Ausgangsform zurückgebracht werden kann. Die erste Form absorbiert bei 515 nm und fluoresziert nicht. Die zweite Form, die im grünen Bereich emittiert, sollte ein Absorptionsband haben, das im Vergleich zu der Ausgangsform verschoben ist und absorbiert das einfallende Licht bei 365 bzw. 336 nm. Diese optische Bistabilität, die keine thermische Deaktivierung durchläuft, und die Fähigkeit, dreidimensionale Kristalle zu bilden, sollen wichtige Merkmale für die Biochipentwicklung auf der Basis des beschriebenen Proteins sein.

Aus der US 5,268,862 ist es bekannt, ein photochromes Material, insbesondere ein Spirobenzopyran, in einer dreidimensionalen Matrix vorzusehen. Wenn diese Matrix in ausgewählten Bereichen gleichzeitig mit Licht zweiter Wellenlängen beleuchtet wird, ändert sich der Zustand des photochromen Materials durch einen Zweiphotonenabsorptionsprozess von einer Spiropyranform in eine Merozyaninform. Bereiche, die nicht zeitlich und räumlich mit dem Licht beider Wellenlängen beleuchtet werden, bleiben unverändert. Spätere Beleuchtungen der ausgewählten Bereiche mit zwei grünroten optischen Signalen gleicher Wellenlänge bringen nur die zweite Merozyanin-Form zur Fluoreszenz, die detektierbar ist.

Aus der US 3,712,813 ist es bekannt, einen sogenannten Photoresist beim Herstellen von Halbleiterschaltungen mit einem Hologramm, d. h. einer durch Interferenz erzeugten Intensitätsverteilung zu belichten.

Ein Verfahren mit den Merkmalen des Oberbegriffs des Patentanspruchs 1 entspricht der Verwendung von sogenannten negativen Photoresists, d. h. von lichtempfindlichen Schichten, die nach einer Belichtung dort chemisch entfernbar sind, wo sie nicht belichtet wurden. Die Verwendung von negativen Photoresists ist z. B. in der US 4,104,070 A und der US 5,403,435 A beschrieben.

Das lokale Intensitätsminimum des optischen Signals wird bei dem neuen Verfahren durch Interferenz erzeugt. Dabei ist der Begriff Interferenz sehr weit zu fassen. So werden nicht zwingend zwei oder noch mehr Lichtstrahlen miteinander überlagert. Beispielsweise können auch die beim Fokussieren eines Lichtstrahls auftretenden lnterferenzeffekte genutzt werden.

Die Sättigung beim Verändern der Substanz mit dem optischen Signal wird erreicht, indem das optische Signal außerhalb des gezielt ausgelassenen räumlich begrenzten Teilbereichs mit einer Intensität oberhalb eines Sättigungsgrenzwerts aufgebracht wird, ab dem die Substanz von dem optischen Signal vollständig bzw. zumindest im Wesentlichen vollständig verändert wird. Es versteht sich, dass zum Unterschreiten der Beugungsgrenze der Sättigungsgrenzwert nicht nur am Ort der Intensitätsmaxima erreicht wird, die dem Intensitätsminimum in dem räumlich begrenzten Teilbereich benachbart sind. Vielmehr muss der Sättigungsgrenzwert auch näher an dem lokalen Intensitätsminimum liegend überschritten werden, um die Beugungsgrenze effektiv zu unterschreiten. Dies ist durch eine Erhöhung der Intensität des optischen Signals zu erreichen.

Das neue Verfahren kann dazu genutzt werden, ein-, zwei- oder auch dreidimensionale Strukturen in dem Schreibbereich zu erzeugen. Dabei versteht sich, dass der Schreibbereich entsprechend der gewünschten Dimensionalität der Struktur ausgebildet und mit der Substanz versehen sein muss. Vorzugsweise ist die Substanz in dem Schreibbereich homogen verteilt oder systematisch angeordnet, um für gleichbleibende Verhältnisse über den gesamten Schreibbereich zu sorgen.

Um die Struktur in dem Schreibbereich vollständig auszubilden, ist es vorgesehen, dass der Schreibbereich mit dem von dem optischen Signal gezielt ausgelassenen Teilbereich abgerastert wird. Da die Struktur auch in mehreren voneinander beabstandeten Punkten, d.h. mehreren räumlich begrenzten Teilbereichen, gleichzeitig erzeugt werden kann, kann der Schreibbereich auch mit mehreren von dem optischen Signal gezielt ausgelassenen Teilbereichen gleichzeitig abgerastert werden. Damit wird der Zeitbedarf für die Erzeugung der jeweiligen Struktur reduziert.

Da jede von dem optischen Signal gezielt ausgelassene Teilbereich ein lokales Intensitätsminimum eines Interferenzmusters ist, kann das Abrastern durch die Verschiebung eines oder mehrerer Interferenzminima des optischen Signals erfolgen. Diese Verschiebung kann durch eine Phasenverschiebung der interferierenden Strahlen bewirkt werden.

Bei dem neuen Verfahren kann bei Datenpunkten, die in einen optischen Speicher eingeschrieben werden und die sich durch besondere Schärfe und geringe Abmessungen auszeichnen, auch der Abstand solcher Datenpunkte unter die Beugungsgrenze gebracht werden. Hierzu wird die Substanz aus der Gruppe von Substanzen ausgewählt, die mit dem optischen Signal wiederholt aus einem ersten Zustand mit ersten Eigenschaften in einen zweiten Zustand mit zweiten Eigenschaften überführbar sind und die aus dem zweiten Zustand in den ersten Zustand zurück bringbar sind, wobei die Substanz nur in dem ersten Zustand mit einem Schreibsignal dauerhaft in den anderen Zustand veränderbar ist. D.h., hier ist das optische Signal noch nicht das Schreibsignal, welches zusätzlich aufgebracht wird. Das optische Signal wird vielmehr genutzt, um die Substanz außerhalb des gezielt ausgelassenen Teilbereichs in den Zustand zu versetzen, der hier als zweiter Zustand bezeichnet ist und aus dem heraus keine dauerhafte Veränderung der Substanz mit dem Schreibsignal erfolgt. Die nur vorübergehende Überführung der Substanz mit dem optischen Signal von ihrem ersten Zustand in ihren zweiten Zustand ist bei dieser zweiten Ausführungsform des neuen Verfahrens Voraussetzung dafür, dass auch beim Abstand der Details der erzeugten Struktur die Beugungsgrenze unterschritten werden kann. Die Struktur wird immer nur in einem Teilbereich mit dem Schreibsignal verändert, der kleinere Abmessungen als die Beugungsgrenze aufweist. Ob in der Umgebung dieses Teilbereichs weitere Veränderungen vorgenommen werden, ist hierdurch noch nicht vorgegeben. Die ersten und zweiten Eigenschaften der Substanz in ihrem ersten und ihrem zweiten Zustand müssen nicht zwingend "binär" sein, d.h. die Veränderbarkeit der Substanz mit dem Schreibsignal braucht nicht in dem ersten Zustand zu 100 % und in dem zweiten Zustand zu 0 % vorzuliegen. Es ist vielmehr ausreichend, wenn diese Eigenschaften in Bezug auf das Schreibsignal so große Unterschiede aufweisen, dass eine eindeutige Zuordnung des Schreibsignals zu dem ersten Zustand gegeben ist, so dass die Substanz im Wesentlichen nur in ihrem ersten Zustand von dem Schreibsignal dauerhaft verändert wird.

In einer bevorzugten Variante des neuen Verfahrens ist das Schreibsignal, das zusätzlich zu dem optischen Signal aufgebracht wird, ebenfalls ein optisches Signal. In diesem Fall umfassen die ersten und die zweiten Eigenschaften der Substanz in ihrem ersten und ihrem zweiten Zustand auch unterschiedliche optische Eigenschaften, wobei nur die ersten Eigenschaften das optische Schreibsignal unterstützen. Das Schreibsignal kann auch aus dem nicht sichtbaren Bereich des elektromagnetischen Spektrums kommen, beispielsweise aus dem fernen Infrarot- oder dem Mikrowellenbereich. Ebenso können elektromagnetische Strahlen einer Wellenlänge kleiner 250 nm als optisches Schreibsignal zum Einsatz kommen. In jedem Fall bleibt als Vorteil gegenüber dem Stand der Technik, dass das Schreibsignal nicht auf den Teilbereich fokussiert werden muss, der innerhalb des Schreibberelchs dauerhaft verändert werden soll, denn die räumliche Festelegung der dauerhaft zu verändernden Teilbereiche erfolgt durch die räumliche Festlegung des zweiten Zustands der Substanz mit Hilfe des optischen Signals. So kann das Schreibsignal auch ein nicht-etektromagnetisches Signal, also beispielsweise thermisch oder chemisch, sein.

Substanzen mit zwei unterschiedlichen Zuständen mit Unterschiedlichen Eigenschaften, die für das neue Verfahren geeignet sind, können aus der Untergruppe von Substanzen ausgewählt werden, bei denen die beiden Zustände mit den unterschiedlichen Eigenschaften unterschiedliche Konformationszustände eines Moleküls oder einer Molekülgruppe oder unterschiedliche chemische Bindungen aufweisen und/oder durch eine Photoisomerisierung oder Photozyklisierung ineinander überführbar sind. Das optische Signal kann bei der Substanz entsprechend eine Umlagerung von Bindungen oder Atomgruppen, eine cis-trans Isomerisierung, eine Zyklisierungsreaktion, eine Protonierung/De-Protonierüng, eine Spin-Umklappung, eine Orientierungsänderung von Molekülen oder Molekülgruppen, und/oder einen Elektronentransfer und/oder Energietransfer zwischen verbundenen Molekülen oder Molekülunteräinheiten auslösen.

Ein großer Vorteil des neuen Verfahrens besteht darin, dass die beiden Zustände mit den ersten und zweiten Eigenschaften vieler in Frage kommender Substanzen eine um ein Vielfaches längere Lebensdauer als beispielsweise an einer Fluoreszenz beteiligte Energiezustände eines Farbstoffs aufweisen. Zudem sind die Intensitäten, die zum Erreichen der Sättigung beispielsweise einer Konformationsänderung erforderlich sind, relativ gering. Zustandsänderungen, bei denen der Ausgangszustand und/oder der Endzustand relativ langlebig (größer. 100 ns) ist, können mit vergleichsweise niedrigen intensitäten des optischen Signals bewirkt werden. Je langlebiger die Zustände sind, desto geringer sind die benötigten Intensitäten.

Bevorzugt sind bei dem neuen Verfahren Substanzen, die mit einem Schaltsignal aus dem zweiten Zustand in den ersten Zustand überführbar sind. Mit dem Schaltsignal kann dann die Überführung der Substanz mit dem optischen Signal in den zweiten Zustand gezielt rückgängig gemacht werden. Das Schaltsignal kann ein optisches Schaltsignal sein. Es kann sich aber auch um ein elektrisches oder thermisches Signal oder auch ein Signal aus dem nichtoptischen Teil des elektromagnetischen Spektrums handeln. Es ist weiterhin möglich, dass die Substanz spontan in ihren ersten Zustand zurückkehrt, d.h. bei Umgebungstemperatur thermisch getrieben. So ist es bekannt, dass Moleküle, die eine photoinduzierte cis-trans Isomerisierung durchlaufen, rein thermisch in den ersten Zustand zurück kommen können. Mit einem Schaltsignal, das die Substanz gezielt in den ersten Zustand zurück bringt, kann das Verfahren aber in aller Regel beschleunigt oder zumindest besser kontrolliert werden.

Um unerwünschte Wechselwirkungen zwischen den verschiedenen Signalen bei dem neuen Verfahren auszuschließen, ist es bevorzugt, wenn die dauerhafte Veränderung der Substanz mit dem Schreibsignal in den anderen Zustand weder durch das optische Signal noch durch das Schaltsignal rückgängig gemacht wird.

Das Schaltsignal wird vor oder, sofern das erfolgreiche Überführen der Substanz in den zweiten Zustand durch das optische Signal hierdurch nicht grundsätzlich in Frage gestellt wird, zusammen mit dem optischen Signal auf den Schreibbereich aufgebracht.

Insbesondere ist es nicht erforderlich, das Schaltsignal auf die Teilbereiche des Schreibbereichs einzugrenzen, in denen aktuell die Struktur erzeugt wird. Die räumliche Eingrenzung beim Erzeugen der Struktur wird bei dem neuen Verfahren durch das optische Signal geleistet.

Das Schreibsignal, das bei dem neuen Verfahren ebenfalls nicht auf die zu verändernden Teilbereiche des Schreibbereichs lokalisiert zu werden braucht, wird nach oder gleichzeitig mit dem optischen Signal auf die Probe aufgebracht. Bei einer gleichzeitigen Aufbringung ist wieder zu beachten, dass keine wechselseitige Störung auftreten darf.

Obwohl, wie voranstehend angesprochen, eine zeitliche Überschneidung der Signale möglich ist, wird das Verständnis des neuen Verfahrens bei einer Betrachtung der folgenden Signalabfolgen erleichtert, die sich zyklisch wiederholt. Die Substanz befindet sich in dem Schreibbereich in ihrem ersten Zustand. Mit dem optischen Signal wird die Substanz in Teilbereichen des Schreibbereichs in ihren zweiten Zustand überführt. Hierbei wird der räumlich begrenzte Teilbereich ausgelassen, indem die Substanz dauerhaft verändert werden soll und in dem sie sich weiterhin in ihrem ersten Zustand befindet. Mit dem Schreibsignal wird anschließend in dem Teilbereich die Substanz dauerhaft in ihren anderen Zustand verändert. Hiernach wird die Substanz in dem Schreibbereich wieder in ihren ersten Zustand gebracht. Dies kann mit Hilfe des Schaltsignals erfolgen. Danach beginnt der Zyklus wieder von vorne an einer anderen Stelle des Schreibbereichs. Bei einem weniger stark lokalisierten Schreibsignal muss auch das optische Signal, das die Substanz in ihren gegenüber dem Schreibsignal unempfindlichen zweiten Zustand überführt den Schreibbereich großflächig abdecken. Bei einem stärker lokalisierten Schreibsignal ist dies nicht notwendig. Der Zeitpunkt des Vorhandenseins der einzelnen Signal bei dem neuen Verfahren bestimmt sich nach dem Erreichen bestimmter Intensitäten. So können auch zeitlich periodische Modulationen der Signale vorgenommen werden, um die zyklische Abfolge der Signals zu realisieren.

Die Substanz kann beispielsweise aus der Gruppe der Proteine ausgewählt werden. Hierzu gehören die bekannten Proteine asCP (asF595) und T70a/A148S/S165V. welche über zwei Konformationszustände mit unterschiedlichen optischen Eigenschaften verfügen, oder auch das Green-Fluorescent-Protein (GFP) und davon abgeleitete Mutanten.

Die dauerhafte Veränderung der Substanz in den anderen Zustand kann Irreversibel oder reversibel sein. Wenn sie reversibel ist, sollte ihre Umkehrung weder durch das Umschaltsignal noch ein anderes der bei der ursprünglichen Veränderung eingesetzten Signale bewirkt werden. Vielmehr sollte zur Aufhebung der Veränderung ein weiteres Signal mit anderen Eigenschaften notwendig sein.

Wenn der andere Zustand der Substanz, in den sie nach dem neuen Verfahren dauerhaft überführt wird, beispielsweise eine veränderte optische Eigenschaft aus der Absorption, Streuung und Polarisierung umfassenden Gruppe oder eine veränderte Lumineszenz aus der Fluoreszenz, Phosphoreszenz, Elektrolumineszenz und Chemolumineszenz umfassenden Gruppe aufweist, kann die erzeugte Struktur des anderen Zustands mit einem Teststrahl ausgelesen werden.

Bei. Ausnutzung der Möglichkeiten der vorliegenden Erfindung, kann mit dem neuen Verfahren ein optischer Datenspeicher mit besonders hoher, Datendichte beschrieben werden, die nicht mehr durch, die Beugungsgrenze limitiert ist. Ebenso können Mikro- und Nanostrukturen mit einer Ober die Beugungsgrenze hinaus verbesserten Auflösung geschrieben bzw. ausgebildet werden.

Die im Anspruch 22 definierte neue Vorrichtung kann zur Durchführung des neuen Verfahrens verwendet werden und eignet sich besonders als optischer Datenspeicher.

### KURZBESCHREIBUNG DER FIGUREN

Im Folgenden werden die Grundlagen der Erfindung anhand von in den Figuren dargestellten Details weiter erläutert und beschrieben.
- **Fig.1**: zeigt symbolisch zwei unterschiedliche Zustände eines Moleküls, das als Substanz bei der zweiten Ausführungsform des neuen Verfahrens einsetzbar ist.

- Fig. 2: zeigt eine beispielhafte zyklische Abfolge von Signalen bei der zweiten Ausführungsform des neuen Verfahrens.
- Fig. 3: zeigt schematisch eine Anordnung zur Durchführung des neuen Verfahrens.

### FIGURENBESCHREIBUNG

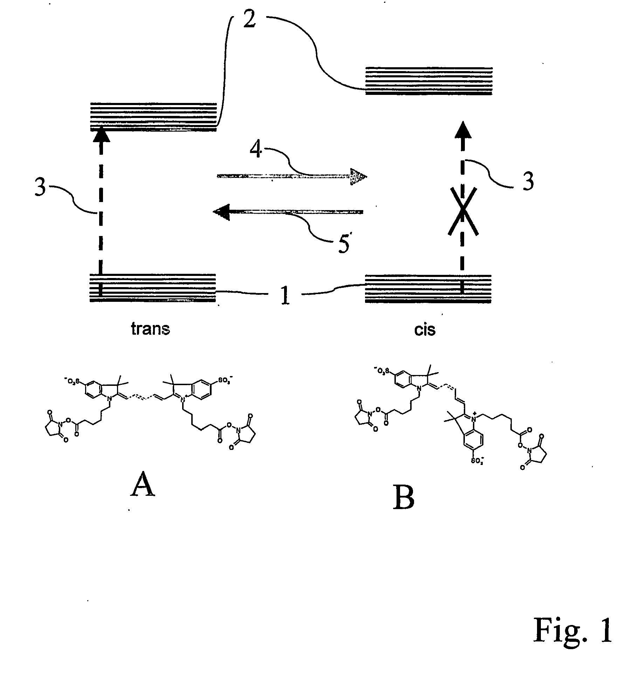

Fig. 1 zeigt Strukturformeln und Energiezustände eines Moleküls, das sich in zwei verschiedenen Zuständen A und B befinden kann. Aus dem Zustand A heraus, der in der voranstehenden Beschreibung und in den Ansprüchen auch als erster Zustand bezeichnet ist, ist das Molekül mit einem Schreibsignal 3 in einen hier selbst nicht dargestellten anderen Zustand dauerhaft veränderbar; aus dem Zustand A heraus, der in der vorangegangenen Beschreibung und in den Ansprüchen auch als erster Zustand bezeichnet ist, hingegen nicht. Konkret überführt das optische Schreibsignal 3 das Molekül im Zustand A hier aus einem energetischen Grundzustand 1 in einen energetisch angeregten Zustand 2, aus dem heraus es dauerhaft in den nicht dargestellten anderen Zustand gelangt. Dabei sind die Zustände A und B zwei Isomere (trans und cis) eines Moleküls, das mittels Photoisomerisation durch ein optisches Signal 4 aus dem Zustand A in den Zustand B und durch ein ebenfalls optisches Schaltsignal 5 aus dem Zustand B zurück in den Zustand A überführbar ist. Das Schreibsignal 3 bewirkt im Zustand B aus Gründen zu geringer Photonenenergie keine dauerhafte Veränderung, da der hier höher liegende energetisch angeregte Zustand 2 nicht erreicht wird.

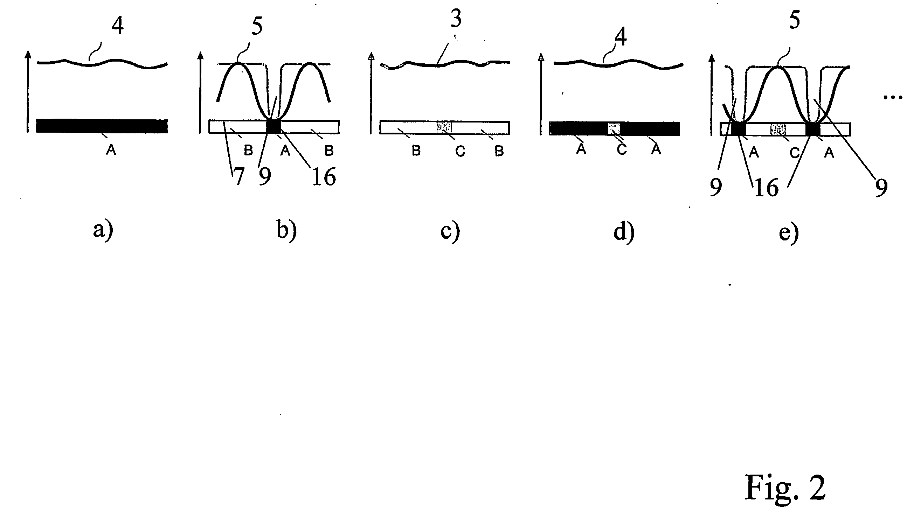

**Fig.2** zeigt eine bevorzugte zyklische Abfolge der Signale, das heißt des optischen Signals 5, des Schaltsignals 4 und des Schreibsignals 3. Neben den Zuständen A und B ist in den Teilfiguren 2 c) bis e) auch der dauerhaft veränderte Zustand C der betrachteten Substanz wiedergegeben. Die von den Teilfiguren dargestellte Abfolge ist: a) Das Schaltsignal 4 schaltet die Substanz in den beschreibbaren Zustand A, b) Das über mindestens ein lokales Intensitätsminimum 9 verfügende optische Signal 5 wird auf den Schreibbereich 7 appliziert und schaltet die Substanz außerhalb des Intensitätsminimums 9 vom Zustand A in den Zustand B. Aufgrund der Sättigung des Umschaltprozesses ist der räumliche Teilbereich, in dem die Substanz noch im Zustand A verbleibt, auf Abmessungen reduziert, die nur von dem Sättigungsgrad und der ursprünglichen Steilheit oder Breite des lntensitätsminimums abhängig sind. c) Das Schreibsignal 3 überführt die Substanz im Zustand A, aber nicht diejenigen im Zustand B dauerhaft in den Zustand C. d) Das Schaltsignal 4 schaltet die nicht in den Zustand C überführte Substanz wieder in den Zustand A.e) Das optische Signal 5 wird erneut appliziert, wobei die Nullstelle 16 des mindestens einen Intensitätsminimums 9 an einen anderen Ort des Schreibbereichs 7 positioniert wird.

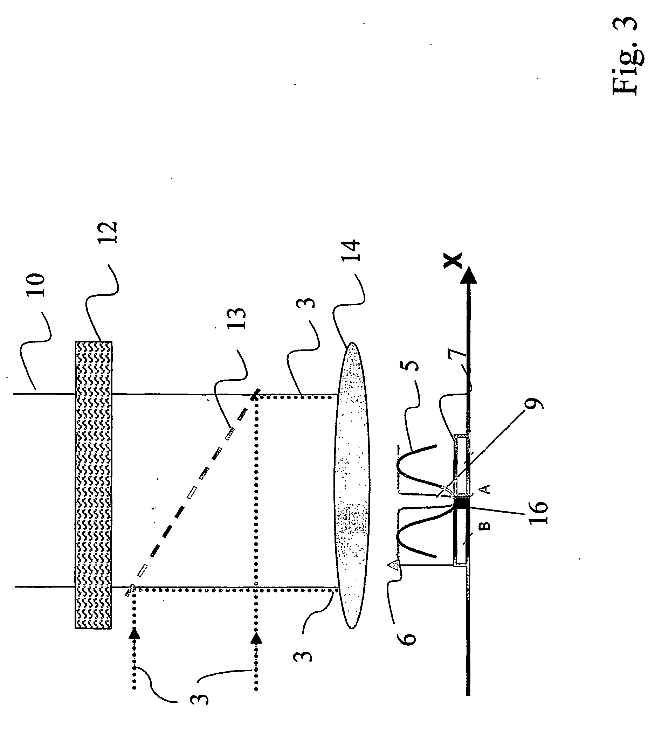

**Fig. 3** zeigt schematisch eine mögliche Anordnung zur Durchführung der Erfindung. Optische Strahlen 10 des optischen Signals 5 werden durch einen Wellenfrontdeformator 12 so deformiert, dass sie nach dem Passieren eines dichroitischen Spiegels 13 und eines Objektivs 14 in dem Schreibbereich 7 ein lnterferenzmuster mit dem die Nullstelle 16 aufweisenden Intensitätsminimum 9 ausbilden. Das optische Signal sättigt den Übergang 6 von dem Zustand A in den Zustand B, so dass entlang der wiedergegebenen Ortskoordiante X nur ein Subdiffraktionsbereich der Substanz im Zustand A verbleibt. Das Schreibsignal 3, das über den dichroitischen Spiegel 13 und das Objektiv 4 auf den Schreibbereich 7 aufgebracht wird, überführt die Substanz im Zustand A dauerhaft in den anderen Zustand C.

## Patentansprüche

1. Verfahren zum räumlich hochaufgelösten Erzeugen einer dauerhaften Struktur, wobei eine Substanz, die mit einem optischen Signal (5) veränderbar ist, in einem Schreibbereich (7) in einem ersten Zustand (A) mit ersten Eigenschaften bereitgestellt wird und wobei das optische Signal (5) so auf den Schreibbereich (7) aufgebracht wird, dass es einen räumlich begrenzten Teilbereich (9) gezielt auslässt, in dem ein dauerhaft veränderter Zustand (C) der Substanz eingestellt wird, während in den von dem optischen Signal erfassten Teilbereichen des Schreibbereichs (7) die Substanz in einen zweiten Zustand (B) mit zweiten Eigenschaften überführt wird, **dadurch gekennzeichnet, dass** die Substanz aus der Gruppe von Substanzen ausgewählt wird, die mit dem optischen Signal (5) wiederholt aus dem ersten Zustand (A) in den zweiten Zustand (B) überführbar sind und die aus dem zweiten Zustand (B) in den ersten beschreibbaren Zustand (A) thermisch oder mit einem Schaltsignal (4) zurück bringbar sind, wobei die Substanz nur in dem ersten Zustand (A) mit einem Schreibsignal (3) in den dauerhaft veränderten Zustand (C) veränderbar ist, wobei das Verfahren nachfolgende Schritte in folgender Reihenfolge enthält:
a) die Substanz wird in den ersten beschreibbaren Zustand (A) gebracht;
b) das optische Signal (5), das den räumlich begrenzten Teilbereich (9) gezielt auslässt, wird auf den Schreibbereich (7) appliziert und schaltet die Substanz außerhalb des räumlich begrenzten Teilbereichs (9) vom ersten beschreibbaren Zustand (A) in den zweiten Zustand (B), während im Bereich des räumlich begrenzten Teilbereichs (9) die Substanz im ersten beschreibbaren Zustand (A) verbleibt;
c) das Schreibsignal (3) überführt denjenigen Teil der Substanz, der sich im ersten beschreibbaren Zustand (A) befindet, in einen dauerhaft veränderten Zustand (C), während derjenige Teil der Substanz, der sich im zweiten Zustand (B) befindet, im zweiten Zustand (B) verbleibt;
d) derjenige Teil der Substanz, der sich im zweiten Zustand (B) befindet, wird wieder in den ersten beschreibbaren Zustand (A) gebracht;
e) das optische Signal (5) wird appliziert, wobei der gezielt ausgelassene räumlich begrenzte Teilbereich (9) an einen anderen Ort des Schreibbereichs (7) positioniert wird, wobei das optische Signal (5) die Substanz außerhalb des räumlich begrenzten Teilbereichs (9) vom ersten beschreibbaren Zustand (A) in den zweiten Zustand (B) schaltet, während im Bereich des räumlich begrenzten Teilbereichs (9) die Substanz im ersten beschreibbaren Zustand (A) verbleibt.

2. Verfahren nach Anspruch 1, **dadurch gekennzeichnet, dass** der von dem optischen Signal (5) gezielt ausgelassene Teilbereich ein lokales Intensitätsminimum (9) des optischen Signals (5) mit einer Nullstelle (16) ist, das durch Interferenz erzeugt wird, und dass das optische Signal (5) außerhalb des gezielt ausgelassenen räumlich begrenzten Teilbereichs (9) so aufgebracht wird, dass beim Verändern der Substanz mit dem optischen Signal (5) die Sättigung erreicht wird, so dass die Substanz in dem Schreibbereichs nur innerhalb des von dem optischen Signal (5) gezielt ausgelassenen räumlich begrenzten Teilbereichs (9) durch das Schreibsignal (3) dauerhaft verändert wird.

3. Verfahren nach Anspruch 2, **dadurch gekennzeichnet, dass** das optische Signal (5) außerhalb des gezielt ausgelassenen räumlich begrenzten Teilbereichs (9) mit einer Intensität oberhalb eines Sättigungsgrenzwerts aufgebracht wird, ab dem die Substanz von dem optischen Signal vollständig verändert wird.

4. Verfahren nach einem der Ansprüche 1 bis 3, **dadurch gekennzeichnet, dass** durch das dauerhafte Einstellen eines anderen Zustands der Substanz eine ein-, zwei- oder dreidimensionale Struktur in dem Schreibbereich (7) erzeugt wird.

5. Verfahren nach einem der Ansprüche 1 bis 4, **dadurch gekennzeichnet, dass** die Substanz in dem Schreibbereich (7) homogen verteilt oder systematisch angeordnet wird.

6. Verfahren nach einem der Ansprüche 1 bis 5, **dadurch gekennzeichnet, dass** der Schreibbereich (7) mit dem von dem optischen Signal (5) gezielt ausgelassenen Teilbereich abgerastert wird.

7. Verfahren nach Anspruch 6, **dadurch gekennzeichnet, dass** der Schreibbereich (7) mit mehreren von dem optischen Signal (5) gezielt ausgelassenen Teilbereichen gleichzeitig abgerastert wird.

8. Verfahren nach einem der Ansprüche 1 bis 7, **dadurch gekennzeichnet, dass** das Schreibsignal (3) ein optisches Schreibsignal (3) ist.

9. Verfahren nach einem der Ansprüche 1 bis 8, **dadurch gekennzeichnet, dass** die Substanz aus der Untergruppe von Substanzen ausgewählt wird, bei denen die beiden Zustände (A und B) mit den unterschiedlichen Eigenschaften unterschiedliche Konformationszustände eines Moleküls oder einer Molekülgruppe oder unterschiedliche chemische Bindungen aufweisen und/oder durch eine Photoisomerisierung oder Photocyclisierung ineinander überführbar sind.

10. Verfahren nach einem der Ansprüche 1 bis 9, **dadurch gekennzeichnet, dass** die Substanz aus der Untergruppe von Substanzen ausgewählt wird, die mit dem Schaltsignal (4) aus dem zweiten Zustand (B) in den ersten Zustand (A) überführbar sind.

11. Verfahren nach Anspruch 10, **dadurch gekennzeichnet, dass** das Schaltsignal (4) ein optisches Schaltsignal (4) ist.

12. Verfahren nach Anspruch 10 oder 11, **dadurch gekennzeichnet, dass** die dauerhafte Veränderung der Substanz mit dem Schreibsignal (3) in den anderen Zustand (c) weder durch das optische Signal (4) noch durch das Schaltsignal (5) rückgängig gemacht wird.

13. Verfahren nach einem der Ansprüche 10 bis 12, **dadurch gekennzeichnet, dass** das Schaltsignal (4) vor oder gleichzeitig mit dem optischen Signal (5) auf den Schreibbereich (7) aufgebracht wird.

14. Verfahren nach einem der Ansprüche 10 bis 13, **dadurch gekennzeichnet, dass** das Schaltsignal (4) über den gezielt ausgelassenen Teilbereich und über von dem optischen Signal (5) erfasste Teilbereiche auf den Schreibbereich (7) aufgebracht wird.

15. Verfahren nach einem der Ansprüche 1 bis 14, **dadurch gekennzeichnet, dass** das Schreibsignal (3) über von dem optischen Signal (5) erfasste Teilbereiche und den gezielt ausgelassenen Teilbereich auf den Schreibbereich (7) aufgebracht wird.

16. Verfahren nach einem der Ansprüche 1 bis 15, **dadurch gekennzeichnet, dass** das Schreibsignal (3) nach oder gleichzeitig mit dem optischen Signal (5) auf den Schreibbereich (7) aufgebracht wird.

17. Verfahren nach einem der Ansprüche 1 bis 16, **dadurch gekennzeichnet, dass** die Substanz aus der Gruppe von Substanzen ausgewählt wird, die Proteine umfassen.

18. Verfahren nach einem der Ansprüche 1 bis 17, **dadurch gekennzeichnet, dass** der andere Zustand der Substanz eine veränderte optische Eigenschaft aus der Absorption, Streuung und Polarisierung umfassenden Gruppe aufweist.

19. Verfahren nach einem der Ansprüche 1 bis 17, **dadurch gekennzeichnet, dass** der andere Zustand der Substanz eine veränderte Lumineszenz aus der Fluoreszenz, Phosphoreszenz, Elektrolumineszenz und Chemolumineszenz umfassenden Gruppe aufweist.

20. Anwendung eines Verfahrens nach einem der Ansprüche 1 bis 19. zum Schreiben in einen Datenspeicher.

21. Anwendung eines Verfahrens nach einem der Ansprüche 1 bis 19 zur Erzeugung mikro- oder nanolithographischer Strukturen.

22. Vorrichtung mit einem dauerhaft strukturierbaren Schreibbereich (7), in dem eine Substanz, die mit einem optischen Signal (5) veränderbar ist, in einem ersten Zustand (A) mit ersten Eigenschaften bereitgestellt ist, wobei in einem räumlich begrenzten Bereich (9), den das optische Signal (5) gezielt auslässt, ein dauerhaft veränderter Zustand (C) der Substanz einstellbar ist, während in den von dem optischen Signal erfassten Teilbereichen des Schreibbereichs (7) das optische Signal (5) die Substanz in einen zweiten Zustand (B) mit zweiten Eigenschaften überführt, **dadurch gekennzeichnet, dass** die Substanz aus der Gruppe von Substanzen ausgewählt ist, die mit dem optischen Signal (5) wiederholt aus dem einen Zustand (A) in den zweiten Zustand (B) überführbar sind und die aus dem zweiten Zustand (B) in den ersten beschreibbaren Zustand (A) thermisch oder mit einem Schaltsignal (4) zurück bringbar sind, wobei die Substanz nur in dem ersten Zustand (A) mit einem Schreibsignal (3) in den dauerhaft veränderten Zustand (C) veränderbar ist.

23. Vorrichtung nach Anspruch 22, **dadurch gekennzeichnet, dass** das Schreibsignal (3) ein optisches Schreibsignal (3) ist.

24. Verwendung einer Vorrichtung nach Anspruch 22 oder 23 als optischer Datenspeicher.

## Claims

1. Method of creating a permanent structure with high spatial resolution, wherein a substance which is modifiable by an optical signal (5) is provided in a writing area (7) in a first state (A) with first properties, and wherein the optical signal (5) is applied to the writing area (7) in such way that it purposefully omits a spatially limited partial area (9) in which a permanently modified state (C) of the substance is adjusted, whereas in partial areas of the writing area (7) covered by the optical signal, the substance is transferred into a second state (B) with second properties, **characterized in that** the substance is selected from a group of substances which are repeatedly transferable out of the first state (A) into the second state (B) by the optical signal (5) and which are thermally or by a switching signal (4) returnable out of their second state (B) into their writable first state (A), wherein the substance only in its first state (A) is modifiable by a writing signal (3) into its permanently modified state (C), wherein the method includes the following steps in the following sequence:
a) the substance is brought into the first writable state (A);
b) the optical signal (5) which purposefully omits the spatially limited partial area (9) is applied to the writing area (7) and switches the substance out of the first writable state (A) into the second state (B) outside the spatially limited partial area (9), whereas the substance remains in the first writable state (A) within the area of the spatially limited partial area (9);
c) the writing signal (3) transfers that part of the substance which is in the first writable state (A) into a permanently modified state (C), whereas that part of the substance which is in the second state (B) remains in the second state (B);
d) that part of the substance which is in the second state (B) is brought back into the first writable state (A);
e) the optical signal (5) is applied, wherein the purposefully omitted spatially limited partial area (9) is positioned at another point of the writing area (7), wherein the optical signal (5) switches the substance outside the spatially limited partial area (9) out of the first writable state (A) into the second state (B), whereas the substance remains in the first writable state (A) in the area of the spatially limited partial area (9).

2. Method according to claim 1, **characterized in that** the partial area purposefully omitted by the optical signal (5) is a local intensity minimum (9) of the optical signal (5) having a zero point (16) which is created by interference, and that the optical signal (5) is applied outside the purposefully omitted spatially limited partial area (9) in such a way upon modifying the substance with the optical signal (5) that saturation is achieved so that the substance in the writing area is only permanently modified by the writing signal (3) within the spatially limited partial area (9) purposefully omitted by the optical signal (5)

3. Method according to claim 2, **characterized in that** the optical signal (5) is applied with an intensity above a saturation threshold value above which the substance is completely modified by the optical signal outside the purposefully omitted spatially limited partial area (9).

4. Method according to any of the claims 1 to 3, **characterized in that** a one-, two- or three-dimensional structure is created in the writing area by means of permanently adjusting another state of the substance.

5. Method according to any of the claims 1 to 4, **characterized in that** the substance is homogeneously distributed or systematically arranged in the writing area (7).

6. Method according to any of the claims 1 to 5, **characterized in that** the writing area (7) is scanned with the partial area purposefully omitted by the optical signal (5).

7. Method according to claim 6, **characterized in that** the writing area (7) is simultaneously scanned with a plurality of partial areas purposefully omitted by the optical signal (5).

8. Method according to any of the claims 1 to 7, **characterized in that** the writing signal (3) is an optical writing signal (3)

9. Method according to any of the claims 1 to 8, **characterized in that** the substance is selected from a sub-group of substances in which both states (A and B) having the different properties are different confirmation states of a molecule or molecule group or have different chemical bindings and/or may be transferred from one to the other by photo-isomerisation or photo-cyclisation.

10. Method according to any of the claims 1 to 9, **characterized in that** the substance is selected from that sub-group of substances which are transferable by the switching signal
(4) out of the second state (B) into the first state (A).

11. Method according to claim 10, **characterized in that** the switching signal (4) is an optical switching signal (4).

12. Method according to claim 10 or 11, **characterized in that** the permanent modification of the substance by the writing signal (3) into the other state (C) is neither reversible by the optical signal (4) nor the switching signal (5).

13. Method according to any of the claims 10 to 12, **characterized in that** the switching signal (4) is applied to the writing area (7) previously to or simultaneously with the optical signal (5).

14. Method according to any of the claims 10 to 13, **characterized in that** the switching signal (4) is applied to the writing area (7) over the purposefully omitted partial area and over partial areas-covered by the optical signal (5).

15. Method according to any of the claims 1 to 14, **characterized in that** the writing signal (3) is applied to the writing area (7) over partial areas covered by the optical signal (5) and the purposefully omitted partial area.

16. Method according to any of the claims 1 to 15, **characterized in that** the writing signal (3) is applied to the writing area (7) prior to or simultaneously with the optical signal

17. Method according to any of the claims 1 to 16, **characterized in that** the substance is selected from the group of substances which includes proteins.

18. Method according to any of the claims 1 to 17, **characterized in that** the other state of the substance comprises a modified optical property selected from the group comprising absorption, dispersion and polarization.

19. Method according to any of the claims 1 to 17, **characterized in that** the other state of the substance comprises a modified luminescence from the group including phosphorescence, electro-luminescence and chemo-luminescence.

20. Application of a method according to any of the claims 1 to 19, for writing in a data storage.

21. Application of a method according to any of the claims 1 to 19 for creating micro- or nano-lithographic structures.

22. Device having a permanently structurable writing area (7) in which a substance which is modifiable by an optical signal (5) is provided in a first state (A) having first properties, wherein a permanently modified state (C) of the substance is adjustable in a spatially limited area (9) which is purposefully omitted by the optical signal (5), whereas the optical signal (5) transfers the substance in a second state (B) having second properties within the partial areas of the writing area (7) covered by the optical signal, **characterized in that** the substance is selected from the group of substances which are repeatedly transferable out of the one state (A) into the second state (B) by the optical signal, and which a thermally or by a switching signal (4) returnable out of the second state (B) into the first writable state (A), wherein the substance is only modifiable in the first state (A) by a writing signal (3) into the permanently modified state (C).

23. Device according to claim 22, **characterized in that** the writing signal (3) is an optical writing signal (3).

24. Use of a device according to 22 or 23 as an optical data storage.

## Revendications

1. Procédé pour la production à haute résolution spatiale d'une structure durable, dans lequel une substance, qui peut être modifiée par un signal optique (5) est prévue dans une zone d'écriture (7) dans un premier état (A) avec des premières propriétés, et dans lequel le signal optique (5) est appliqué à la zone d'écriture (7) de telle sorte qu'il ignore délibérément une zone partielle (9) délimitée dans l'espace dans laquelle un état (C) modifié de façon durable de la substance est réglé, alors que dans les zones partielles détectées par le signal optique de la zone d'écriture (7) la substance est amenée à passer à un deuxième état (B) avec des deuxièmes propriétés, **caractérisé en ce que** la substance est choisie dans le groupe de substances qui peuvent être amenées par le signal optique (5) de façon répétée à passer du premier état (A) au deuxième état (B) et qui peuvent être ramenées du deuxième état (B) au premier état inscriptible (A) de façon thermique ou par un signal de commutation (4), dans lequel la substance peut être modifiée uniquement dans le premier état (A) par un signal d'écriture (3) vers l'état (C) modifié de façon durable, le procédé comprenant les étapes ci-dessous dans l'ordre suivant :
a) la substance est amenée dans le premier état inscriptible (A) ;
b) le signal optique (5), qui ignore délibérément la zone partielle (9) délimitée dans l'espace, est appliqué à la zone d'écriture (7) et commute la substance en dehors de la zone partielle (9) délimitée dans l'espace du premier état inscriptible (A) sur le deuxième état (B), alors qu'au niveau de la zone partielle (9) délimitée dans l'espace, la substance reste dans le premier état inscriptible (A) ;
c) le signal d'écriture (3) fait passer la partie de la substance qui se trouve dans le premier état inscriptible (A) à un état (C) modifié de façon durable, alors que la partie de la substance qui se trouve dans le deuxième état (B) reste à l'état (B) ;
d) la partie de la substance qui se trouve dans le deuxième état (B) est ramené au premier état inscriptible (A) ;
e) le signal optique (5) est appliqué, dans lequel la zone partielle (9) délimitée dans l'espace et ignorée délibérément est positionnée à un autre endroit de la zone d'écriture (7), dans lequel le signal optique (5) commute la substance en dehors de la zone partielle (9) délimitée dans l'espace du premier état inscriptible (A) sur le deuxième état (B), alors que dans la zone de la zone partielle (9) délimitée dans l'espace, la substance reste dans le premier état inscriptible (A).

2. Procédé selon la revendication 1, **caractérisé en ce que** la zone partielle ignorée délibérément par le signal optique (5) est un minimum d'intensité local (9) du signal optique (5) avec un point zéro (16) et qui est généré par interférence, et **en ce que** le signal optique (5) est appliqué en dehors de la zone partielle (9) délimitée dans l'espace et ignorée délibérément de telle sorte qu'en cas de modification de la substance par le signal optique (5) la saturation est atteinte de sorte que la substance dans la zone d'écriture est modifiée de façon durable par le signal d'écriture (3) seulement à l'intérieur de la zone partielle (9) délimitée dans l'espace et ignorée délibérément par le signal optique (5).

3. Procédé selon la revendication 2, **caractérisé en ce que** le signal (5) est appliqué en dehors de la zone partielle (9) délimitée dans l'espace et ignorée délibérément avec une intensité au-dessus d'une valeur limite de saturation à partir de laquelle la substance est modifiée complètement par le signal optique.

4. Procédé selon l'une quelconque des revendications 1 à 3, **caractérisé en ce que** le réglage durable d'un autre état de la substance produit une structure en une, deux ou trois dimensions dans la zone d'écriture (7).

5. Procédé selon l'une quelconque des revendications 1 à 4, **caractérisé en ce que** la substance est répartie de façon homogène ou disposée de façon systématique dans la zone d'écriture (7).

6. Procédé selon l'une quelconque des revendications 1 à 5, **caractérisé en ce que** la zone d'écriture (7) est balayée avec la zone partielle ignorée délibérément par le signal optique (5).

7. Procédé selon la revendication 6, **caractérisé en ce que** la zone d'écriture (7) est balayée en même temps que plusieurs zones partielles ignorées délibérément par le signal optique (5).

8. Procédé selon l'une quelconque des revendications 1 à 7, **caractérisé en ce que** le signal d'écriture (3) est un signal d'écriture optique (3).

9. Procédé selon l'une quelconque des revendications 1 à 8, **caractérisé en ce que** la substance est choisie dans le sous-groupe de substances dans lesquelles les deux états (A et B) avec les différentes propriétés présentent différents états de conformation d'une molécule ou d'un groupe de molécules ou différentes liaisons chimiques et/ou peuvent être amenés à passer l'un à l'autre par une photoisomérisation ou une photocyclisation.

10. Procédé selon l'une quelconque des revendications 1 à 9, **caractérisé en ce que** la substance est choisie dans le sous-groupe de substances que le signal de commutation (4) peut faire passer du deuxième état (B) au premier état (A).

11. Procédé selon la revendication 10, **caractérisé en ce que** le signal de commutation (4) est un signal de commutation optique (4).

12. Procédé selon la revendication 10 ou 11, **caractérisé en ce que** la modification durable de la substance par le signal d'écriture (3) dans l'autre état (c) n'est annulée ni par le signal optique (4) ni par le signal de commutation (5).

13. Procédé selon l'une quelconque des revendications 10 à 12, **caractérisé en ce que** le signal de commutation (4) est appliqué à la zone d'écriture (7) avant ou en même temps que le signal optique (5).

14. Procédé selon l'une quelconque des revendications 10 à 13, **caractérisé en ce que** le signal de commutation (4) est appliqué à la zone d'écriture (7) en passant par la zone partielle ignorée délibérément et des zones partielles détectées par le signal optique (5).

15. Procédé selon l'une quelconque des revendications 1 à 14, **caractérisé en ce que** le signal d'écriture (3) est appliqué à la zone d'écriture (7) en passant par des zones partielles détectées par le signal optique (5) et la zone partielle ignorée délibérément.

16. Procédé selon l'une quelconque des revendications 1 à 15, **caractérisé en ce que** le signal d'écriture (3) est appliqué à la zone d'écriture (7) après ou en même temps que le signal optique (5).

17. Procédé selon l'une quelconque des revendications 1 à 16, **caractérisé en ce que** la substance est choisie dans le groupe de substances qui comprend les protéines.

18. Procédé selon l'une quelconque des revendications 1 à 17, **caractérisé en ce que** l'autre état de la substance présente une propriété optique modifiée du groupe comprenant l'absorption, la diffusion et la polarisation.

19. Procédé selon l'une quelconque des revendications 1 à 17, **caractérisé en ce que** l'autre état de la substance présente une luminescence modifiée du groupe comprenant la fluorescence, la phosphorescence, l'électroluminescence et la chimioluminescence.

20. Application d'un procédé selon l'une quelconque des revendications 1 à 19 pour l'écriture dans une mémoire de données.

21. Application d'un procédé selon l'une quelconque des revendications 1 à 19 pour produire des structures micro ou nanolithographiques.

22. Dispositif comprenant une zone d'écriture (7) structurée de façon durable, dans lequel une substance, qui peut être modifiée par un signal optique (5), est prévue dans un premier état (A) avec des premières propriétés, dans lequel dans une zone délimitée dans l'espace (9), que le signal optique (5) ignore délibérément, un état (C) modifié de façon durable de la substance peut être réglé, alors que dans les zones partielles détectées par le signal optique de la zone d'écriture (7), le signal optique (5) fait passer la substance à un deuxième état (B) avec des deuxièmes propriétés, **caractérisé en ce que** la substance est choisie dans le groupe de substances que le signal optique (5) peut de façon répétée faire passer dudit état (A) au deuxième état (B) et qui peuvent être ramenées du deuxième état (B) au premier état inscriptible (A) de façon thermique ou par un signal de commutation (4), dans lequel la substance peut être modifiée uniquement dans le premier état (A) par un signal d'écriture (3) vers l'état (C) modifié de façon durable.

23. Dispositif selon la revendication 22, **caractérisé en ce que** le signal d'écriture (3) est un signal d'écriture optique (3).

24. Utilisation d'un dispositif selon la revendication 22 ou 23 en tant que mémoire de données.
